(19) Europäisches Patentamt
European Patent Office
Office européen des brevets

(11) Publication number: **0 224 325 B1**

# EUROPEAN PATENT SPECIFICATION

(45) Date of publication of patent specification: **22.05.91**

(51) Int. Cl.⁵: **H04N 5/16, H03K 5/08**

(21) Application number: **86307666.7**

(22) Date of filing: **03.10.86**

(54) Low level clamp circuit.

(30) Priority: **07.10.85 JP 223100/85**

(43) Date of publication of application:
**03.06.87 Bulletin 87/23**

(45) Publication of the grant of the patent:
**22.05.91 Bulletin 91/21**

(84) Designated Contracting States:
**DE FR GB NL**

(56) References cited:
**US-A- 3 811 053**
**US-A- 3 970 777**
**US-A- 4 167 682**
**US-A- 4 369 466**
**US-A- 4 451 747**

(73) Proprietor: **SONY CORPORATION**
**7-35 Kitashinagawa 6-Chome Shinagawa-ku**
**Tokyo 141(JP)**

(72) Inventor: **Hiroshi, Mori**
**Sony Corporation 7-35, Kitashinagawa**
**6-chome**
**Shinagawa-ku Tokyo(JP)**

(74) Representative: **Ayers, Martyn Lewis Stanley**
**et al**
**J.A. KEMP & CO. 14 South Square Gray's Inn**
**London, WC1R 5EU(GB)**

## Description

### BACKGROUND OF THE INVENTION

#### Field of the Invention

The present invention relates to a low level clamp circuit for clamping a low level of a multilevel clock having, for example, at least three levels. More specifically, this invention relates to a low level clamp circuit suitably used for clamping a low level of a multilevel clock in which an intermediate level, in particular, is required to be stabilized, for instance when the multilevel clock is used as an image element driving clock for a charge-coupled device (CCD).

#### Description of the Prior Art

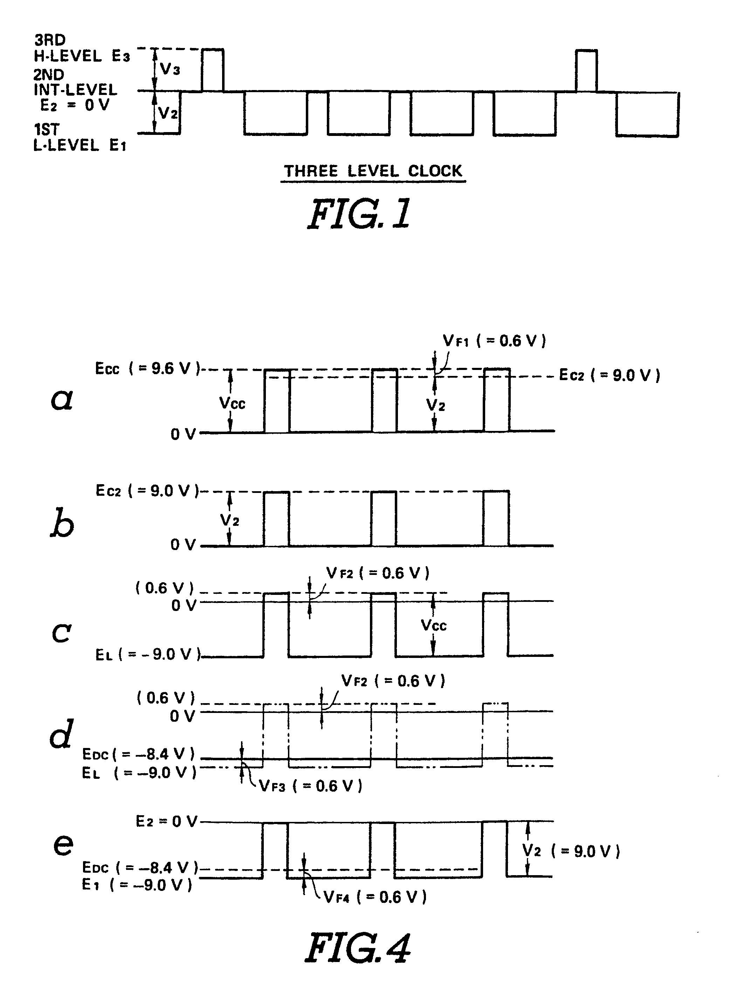

As a driving clock for a vertical register for solid image elements such as a so-called CCD imager, a three-level clock as shown in Fig. 1 is used. Where a clamping operation is used to stabilize the levels of this three-level clock, a low-level clamping operation is preferable to maintain the stability of the clamping operation, since the clamping period is short. In general, when an electric charge of the CCD image elements is transferred, the second intermediate level of a multilevel driving clock is very important. Therefore, it has been especially desirable to improve the accuracy of the second level of the driving clock.

When a three-level clock as shown in Fig. 1 is clamped at its lowest level and then supplied to the CCD image element, there exist drawbacks in that the amplitude in the driving clock changes between the low level and the second intermediate level due to power supply voltage fluctuations or element characteristic fluctuations based upon temperature change. Thus, the clamped second level fluctuates while transferring the electric charge relative to the stable low level. An example of a prior art low level clamp circuit will be described as to circuit configuration and operation under the section captioned DETAILED DESCRIPTION OF THE PREFERRED EMBODIMENTS.

It has remained a problem in the art, however, to clamp a clocked biasing signal at a first level and accurately clamp a second level biasing signal at a value accurately related to the first level.

With these problems in mind, therefore, it is the primary object of the present invention to provide a low level clamp circuit which can stably maintain the intermediate level of a multi level clamping circuit, even if the power supply voltage fluctuates or the temperature characteristics of circuit elements (eg, diodes) fluctuate, in the low level clamp circuit in which the intermediate level, ie, the second level, of an at least three multi-level clock is required to be stabilised. Further, in the circuit of the present invention, since no Zener diode is incorporated, it is possible to avert the harmful influence due to the difference in diode operation characteristics and/or the fluctuations in diode temperature characteristics of a Zener diode.

It may be noted that clamping a signal to one of three levels is known, from US-A-3811053. However, the circuits disclosed in that reference operate to limit excursions in one direction of a video, picture-information containing signal to one of three levels, for the purpose of better preserving the picture-information, rather than to generate a three level clock signal.

According to a first aspect of the invention, there is provided a low level clamp circuit for clamping a clock signal at at least three predefined levels, comprising:-

(a) a first negative bias driving circuit for receiving a negative bias supply voltage and outputting a pulse with an amplitude corresponding to the received negative bias supply voltage in response to a first clock pulse;

(b) a first diode with a first forward voltage drop;

(c) a second intermediate level driving circuit for receiving a negative bias supply voltage via said first diode and outputting a clock pulse with an amplitude corresponding to the received negative bias supply voltage to be stabilised in response to the first clock pulse;

(d) a second diode responsive to said first negative bias driving circuit for clamping a high level of the pulse outputted from said first negative bias driving circuit and outputting a clamped pulse;

(e) a rectifying/smoothing circuit including a third diode and a capacitor responsive to the high level clamped pulse outputted via said second diode for outputting a negative bias dc output and

(f) a fourth diode connected between said second intermediate level driving circuit and said rectifying/smoothing circuit for clamping a low level of the clock pulse outputted from said second intermediate level driving circuit to the rectified/smoothed negative bias dc output.

The invention also provides a low level clamp circuit for clamping a clock signal at at least three predefined levels, comprising:-

a source of a negative bias supply voltage;

input bias driving circuit means in circuit with a source of clock signals having at least two levels to be clamped, said input bias driving circuit means including a first negative bias driving circuit for receiving said negative supply voltage and outputting a pulse corresponding to said negative bias supply voltage in response to a first clock pulse, and a second intermediate level driving circuit for receiving a negative bias supply voltage through a first diode with a first voltage drop in circuit with said negative bias supply voltage, said second intermediate level driving circuit outputting a clock pulse with an amplitude corresponding to the difference between the negative bias supply voltage and the first forward voltage drop of said diode to be stabilised in response to the first clock pulse; a clamping and smoothing circuit means for clamping a high level of the pulse outputted from said first negative bias driving circuit and outputting a clamped pulse therefrom, said clamping and smoothing circuit including a second diode responsive to said first negative bias driving circuit for clamping a high level of the pulse outputted therefrom, and a third diode responsive to the high level clamped pulse outputted via said second diode for outputting a negative bias dc output therefrom; and a fourth diode means connected between said second intermediate level driving circuit and said clamping and smoothing means for clamping a low level of the clock pulse outputted from said second intermediate level driving circuit to said clamping and smoothing means.

These and other features of the invention will become apparent from the detailed description of the invention which follows, taken in conjunction with the accompanying drawings.

## BRIEF DESCRIPTION OF THE DRAWINGS

The features and advantages of the low level clamp circuit according to the present invention will be more clearly appreciated from the following description of the preferred embodiment of the invention taken in conjunction with the accompanying drawings in which:

Fig. 1 is a waveform diagram showing an example of three-level clock pulses;

Fig. 2 is a schematic circuit diagram of a prior art low level clamp circuit;

Fig. 3 is a schematic circuit diagram of an embodiment of the low level clamp circuit according to the present invention; and

Fig. 4 is a waveform diagram for assistance in explaining the operation of the circuit shown in Fig. 3, in which the circled symbols a to e designate each essential junction point in the circuit shown in Fig. 3.

## DETAILED DESCRIPTION OF THE PREFERRED EMBODIMENT

To facilitate an understanding of the present invention, a brief reference will be made to an example of a prior art low level clamp circuit for a three-level clock with reference to the attached drawings.

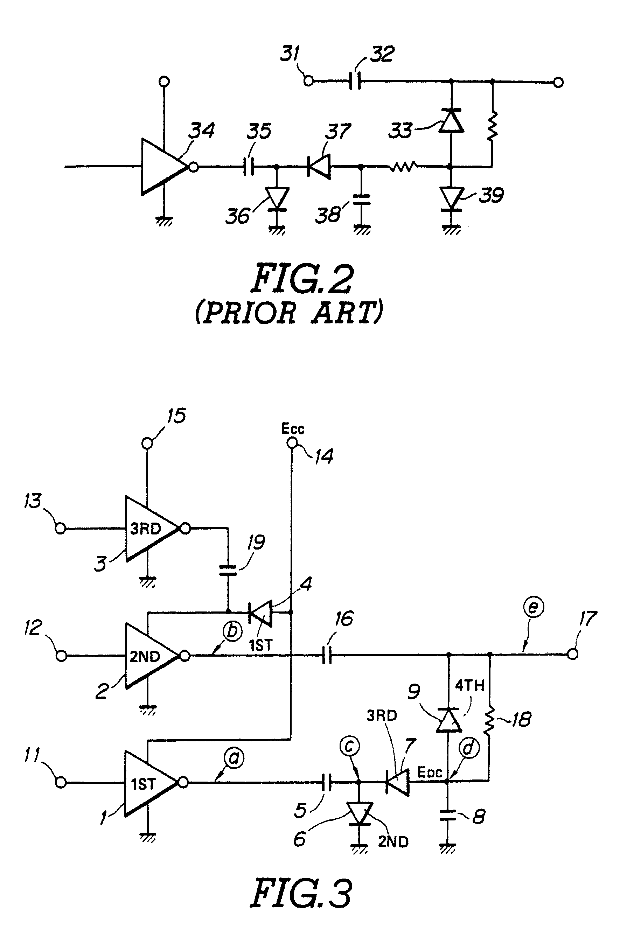

In Fig. 1, a three-level clock signal is shown, having a first low level $E_1$, a second intermediate level $E_2$, and a third high level $E_3$. The amplitude of the first low level is $V_2$, while that of the third high level $E_3$ is $V_3$. The magnitude of the second intermediate level $E_2$ is 0V. Such a multi-level clock is useful as a driving clock for a vertical register for solid image elements, such as in a so-called CCD imager. The respective levels of the clock signal shown in Fig. 1 are preferably clamped, such as by a prior art circuit shown in Fig. 2 for stability.

In Fig. 2, a three-level clock pulse signal of any given level as shown in Fig. 1 is supplied as an input pulse signal to an input terminal 31. The dc component of the input pulse signal is blocked by a dc blocking capacitor 32 and is clamped at a low level by a clamping diode 33. However, in this clamping operation, the negative bias dc voltage for determining the clamp level is obtained as follows. An output pulse having an amplitude sufficiently higher than the pulse amplitude which lies between the first low level and the second intermediate level of the three-level clock is outputted from a negative bias driving circuit 34 and shifted to the negative side via a capacitor 35 and a diode 36. The output pulse is rectified and smoothed via a diode 37 and a capacitor 38 to obtain a sufficiently low bias dc. The output pulse at an output terminal 40 is stabilized by a Zener diode 39 having a Zener voltage corresponding to the low pulse level. A resistor 41 is in parallel with the clamping diode 33, while a resistor 42 receives the rectified and smoothed output pulse.

In the circuit configuration as described above, however, the low level of the three-level clock is thus determined by the Zener voltage of the Zener diode 39. When the amplitude of the three-level clock changes due to power supply voltage fluctuations, the second intermediate level also undesirably fluctuates accordingly. In addition, there exist other problems whereby the clamp level fluctuates due to a change of the temperature characteristics of the low-level clamping diode 33 and to a difference in the operating characteristics of the Zener diode 39, and the fluctuations of the temperature characteristics of the Zener voltage of the Zener diode 39.

Reference is now made to an embodiment of a low-level clamp circuit according to the present invention. The low-level clamp circuit shown in Fig. 3 shows an exemplary circuit suitably applied at a low level to a three-level clock signal used as a transferring and driving clock signal in a CCD image element in a vertical register, as explained together with Fig. 1, in which accuracy is required for the second intermediate level. In the following description, the first low level signal of the three level clock pulse shown in Fig. 1 is denoted as $E_1$; the second intermediate level signal thereof is denoted as $E_2$; the third high level signal thereof is denoted as $E_3$; the voltage amplitude between the first low level signal and the second intermediate level signal is denoted as $V_2$, which is equal to $E_2 - E_1$; the voltage amplitude between the second intermediate level signal and the third high level signal is denoted as $V_3$, equal to $E_3 - E_2$; and the second intermediate level $E_2$ is to be stabilized accurately relative to a ground potential of zero volts (0V).

In Fig. 3, a clock pulse corresponding to a waveform between the first low level $E_1$ and the second intermediate level $E_2$ of the above three-level clock is supplied to an input terminal 11 of a first negative bias driving circuit 1 and an input terminal 12 of a second level driving circuit 2. Further, a pulse corresponding to the waveform of the third high level is supplied to an input terminal 13 of a third-level driving circuit 3. A negative bias voltage $E_{cc}$ is supplied to a voltage supply terminal 14 of the negative bias driving circuit 1 in order to obtain an output at terminal a having an amplitude $V_2$ between the low level $\bar{E_1}$ and the second or intermediate level $E_2$. The actual output of the circuit 1 is higher than $v_2$ by the magnitude of a forward voltage drop $V_{F1}$ of the first diode 4 as described later. Since the negative side voltage supply terminal of the negative bias driving circuit 1 is grounded, the potential $E_{cc}$ of the negative bias supply voltage is equal to the above voltage $V_{cc}$. The supply voltage $E_{cc}$ is also supplied to the second level driving circuit 2 from the negative bias voltage supply terminal 14 through a first diode 4. The above voltage $E_{cc}$, which is equal in magnitude to $V_2 + V_{F1}$, is so determined that the output amplitude of the driving circuit 2 may be equal to the amplitude $V_2$ between the first low level and the second intermediate level as shown in Fig 1. Further, a third-level supply voltage is supplied to a voltage supply terminal 15 of the third-level driving circuit 3 to obtain an output having a voltage amplitude $V_3$ between the second intermediate level $E_2$ and the third high level $E_3$

One terminal of a capacitor 5 is connected to an output terminal a of the negative bias driving circuit 1. An anode of a second diode 6 is connected to the other terminal of the capacitor 5, and a cathode of the second diode 6 is grounded. The second diode 6 is responsive to the first negative bias driving circuit 1 for clamping a high level of the pulse at terminal a outputted from the circuit 1 and outputting a clamped pulse at the terminal c. A cathode of a third diode 7 for rectification is connected to a junction point c between the capacitor 5 and the diode 6. An anode of the third diode 7 is grounded through a smoothing capacitor 8. At the junction point d between the third diode 7 and the capacitor 8, a negative bias dc level $E_{DC}$ for determining the low-level clamp level $E_{DC}$ is produced, and the junction point d is also connected to an anode of a fourth clamping diode 9. A terminal of a capacitor 16 is connected to an output terminal b of the second level driving circuit 2, and the other terminal of the capacitor 16 is connected to a cathode of the clamping diode 9 and an output terminal 17. A resistor 18 is connected in parallel with the clamping diode 9. It is preferable to select each diode 4, 6, 7 and 9 so as to satisfy the formula $V_{F1} + V_{F4} = V_{F2} + V_{F3}$, wherein $V_{F1}$, $V_{F2}$, $V_{F3}$, or $V_{F4}$ denotes each of the forward voltage drops of the first to fourth diodes 4, 6, 7 and 9.

The output pulse from the third level driving circuit 3 is supplied to a voltage supply terminal of the second-level driving circuit 2 through a capacitor 19, for instance, so as to be superposed upon the second intermediate level driving pulse applied to the terminal 12.

In the low level clamp circuit configured as described above, when the output characteristics of the negative bias driving circuit 1 and the second level driving circuit 2 are determined to be equal to each other, a difference between the two supply voltages, that is, a voltage difference corresponding to the forward voltage drop $V_{F1}$ of the first diode 4 appears between the two output pulse amplitudes of the driving circuits 1 and 2. If the assumption is made that the supply voltage appears as if it is as the amplitude of the driving circuit output pulse, the output pulse of the negative bias driving circuit 1 has a voltage $V_{cc}$ between ground potential (0 volts) and the negative bias supply voltage level $E_{cc}$, as shown in Fig. 4a. Thus, the output pulse of the second level driving circuit 2 has an amplitude of a voltage $V_2$ which lies between the first low level voltage and the second intermediate level, i.e, 0 volts. For instance, if the amplitude of the voltage $V_2$ is 9.0V and the forward voltage drop $V_{F1}$ of the first diode 4 is 0.6V, the supply voltage level $E_{c2}$ to be supplied to the second level driving circuit 2 becomes 9.0V, i.e., 9.6 - 0.6, by setting the negative bias supply voltage $E_{cc}$ to 9.6V. Therefore, the potential difference between $E_{c2}$ and the ground is 9.0V. Therefore, it is possible to obtain an output pulse at terminal b with a determined amplitude $V_2$, equal to 9.0V, from the driving circuit 2, as shown in Fig. 4b.

Further, the output pulse with an amplitude $V_{cc}$ from the negative bias driving circuit 1 is fixed so that the pulse high level becomes equal to the forward voltage drop $V_{F2}$ of the second diode 6 higher than the ground level because of the clamping action of the capacitor 5 and the second diode 6. Therefore, a pulse output shifted to the negative side can be obtained as shown in Fig. 4c. The low level $E_L$ of this pulse shown in Fig. 4c is $0 + V_{F2} - V_{cc}$; therefore, if $V_{F2} = 0.6V$, $E_L = -9.0V$.

The output pulse shown in Fig. 4c is rectified and smoothed by the third diode 7 and the capacitor 8, so that a negative bias dc for determining the clamp level can be obtained as shown in Fig. 4d. Because of the forward voltage drop $V_{F3}$ of the third diode 7, the obtained negative bias dc level $E_{DC}$ is raised by $V_{F3}$ to a value $E_{DC}$ equal to $E_L + V_{F3}$ from the low level of $E_L$ for the pulse shown in Fig. 4c. Therefore, if $V_{F3} = 0.6V$, $E_{DC} = -8.4V$, as shown in Fig. 4d.

Although the output pulse with on amplitude $V_2$ as shown in Fig. 4b of the second level driving circuit 2 is a low-level clock signal clamped by the fourth clamping diode 9 with the negative bias dc level $E_{DC}$ as the clamping basis, since the low level $E_1$ of this clamped pulse (see Fig. 4e) becomes a level $E_1$ equal to $E_{DC} - V_{F4}$, i.e., a forward voltage drop $V_{F4}$ of the diode 9 lower than the negative bias dc level $E_{DC}$. If $V_{F4} = 0.6V$, $E_1 = -9.0V$. Therefore, since the pulse amplitude $V_2$ shown in Figs. 4b and 4e is 9.0V, the second intermediate level $E_2$ of the pulse shown in Fig. 4e is set to a desired 0 V.

The amplitude $V_2$ of the pulse shown in Fig. 4e is given by subtracting the forward voltage drop $V_{F1}$ of the first diode 4 from the potential difference $V_{cc}$ between the negative bias supply voltage level $E_{cc}$ and the ground level ($V_2$ $V_{cc} - V_{F1}$). In contrast with this, since the low level $E_1$ of the pulse shown in Fig. 4e is given as a value $E_1$ equal to $E_{DC} - V_{F4}$, a forward voltage drop $V_{F4}$ of the diode 9 lower than the negative bias dc level $E_{DC}$, the second intermediate level can be expressed as

$$E_2 = E_1 + V_2 = E_{DC} - V_{F4} + V_{cc} - V_{F1}$$

Further, as explained with respect to Fig. 4d, since the negative bias dc level $E_{DC}$ can be obtained as $E_1 + V_{F3}$, and $E_L$ can be given as $0 + V_{F2} - V_{cc}$ as shown in Fig. 4c, then

$$E_{DC} \quad E_L + V_{F3} = 0 + V_{F2} - V_{cc} + V_{F3}$$

Therefore, finally $E_2$ can be expressed as

$$E_2 \quad E_{DC} - V_{F4} + V_{cc} - V_{F1}$$

$$= 0 + V_{F2} - V_{cc} + V_{F3} - V_{F4} + V_{cc} - V_{F1}$$

$$= V_{F2} + V_{F3} - (V_{F1} + V_{F4})$$

Therefore, by previously setting $V_{F2} + V_{F3}$ and $V_{F1}$ and $V_{F4}$ so as to be equal to each other, it is always possible with the circuit of Fig. 3 to accurately stabilize $E_2$ to 0 volts, i.e., the ground level, irrespective of the fluctuations of supply voltage. Since it is readily possible to make the temperature characteristics of each of the diodes 4, 6, 7 and 9 equal to those of other diodes in such a way that the temperature characteristic fluctuations of two diodes can cancel those of other two diodes, it is possible to stably maintain the second intermediate level against the fluctuations due to temperature change.

On the other hand, because the current flowing through the fourth clamping diode 9 is generally very small and the forward voltage drop $V_{F4}$ is naturally slightly lowered as compared with other diodes $V_{F1}$ to $V_{F3}$, it is preferable to configure the circuit so that the formula $V_{F1} + V_{F4} = V_{F2} + V_{F3}$ can be established by using Schottky diodes each having a small forward voltage drop, for instance, as the second and third diodes 6 and 7.

A difference between the amplitude $V_{cc}$ of the output pulse of the intermediate level driving circuit 2 and that $V_2$ of the output pulse of the negative bias driving circuit 1 is equal to a forward voltage drop $V_{F1}$ of the first diode; the negative bias dc level obtained by high-level clamping and rectifying/ smoothing the output pulse from the negative bias driving circuit 1 corresponds to a value obtained by subtracting two forward voltage drops $V_{F2}$ and $V_{F3}$ of the second and third diodes from the amplitude $V_{cc}$ of the output pulse of the negative bias driving circuit 1; and the low level, obtained when the output pulse of the driving circuit for the intermediate level is low-level clamped with the negative bias dc level as a clamp level, corresponds to a level obtained by subtracting a forward voltage drop $V_{F4}$ of the fourth diode from the negative bias dc level. Therefore, the intermediate level of the low-level clamped output pulse can be determined according to the value $V_{F2} + V_{F3} - (V_{F1} + V_{F4})$ expressed by each of the forward voltage drops $V_{F1}$ to $V_{F4}$ of the first and fourth diodes. By low-level clamping of a multi-level clock pulse such as a three-level clock pulse, it is possible to readily maintain the intermediate level accurately and stably against the fluctuations of supply voltage and temperature, by selecting the first to fourth diodes so that the value $V_{F2} + V_{F3} - (V_{F1} + V_{F4})$ can always be kept at a constant level including the temperature characteristics thereof. Furthermore, since no Zener diode such as Zener diode 39 in the prior art is used, there exists no level fluctuation due to the difference of Zener diode and/or the change of temperature characteristics thereof.

## Claims

1. A low level clamp circuit for clamping a clock signal at at least three predefined levels, comprising:-

    (a) a first negative bias driving circuit (1) for receiving a negative bias supply voltage ($E_{cc}$) and outputting a pulse (a) with an amplitude corresponding to the received negative bias supply voltage ($E_{cc}$) in response to a first clock pulse;

    (b) a first diode (4) with a first forward voltage drop ($V_{F1}$);

    (c) a second intermediate level driving circuit (2) for receiving a negative bias supply voltage ($V_2$) via said first diode and outputting a clock pulse (b) with an amplitude corresponding to the received negative bias supply voltage ($E_{cc} - V_{F1}$) to be stabilised in response to the first clock pulse;

    (d) a second diode (6) responsive to said first negative bias driving circuit (1) for clamping a high level of the pulse (a) outputted from said first negative bias driving circuit (1) and outputting a clamped pulse (c);

    (e) a rectifying/smoothing circuit including a third diode (7) and a capacitor (8) responsive to the high level clamped pulse (c) outputted via said second diode for outputting a negative bias dc output ($E_{dc}$,d); and

    (f) a fourth diode (9) connected between said second intermediate level driving circuit (2) and said rectifying/smoothing circuit (8) for clamping a low level of the clock pulse (b) outputted from said second intermediate level driving circuit to the rectified/smoothed negative bias dc output ($E_{dc}$,d).

2. The low level clamp circuit as set forth in claim 1, which further comprises:

    a third high level driving circuit (3) for receiving a third positive bias supply voltage ($V_3$) and outputting a pulse to be superimposed upon the negative bias supply voltage ($E_{cc} - V_{F1}$) applied to said second intermediate level driving circuit in response to a second clock pulse.

3. The low level clamp circuit as set forth in claim 1 or 2, wherein the negative bias supply voltage ($E_{cc}$) applied to said first negative bias driving circuit is equal to an addition of the negative bias voltage ($V_2$) applied to said sec-

ond intermediate level driving circuit (2) and the first forward voltage drop ($V_{F1}$) of said first diode (4).

4. The low level clamp circuit as set forth in claim 1, 2 or 3, wherein said first, second, third and fourth diodes (4, 6, 7, 9) are determined so that $V_{F1} + V_{F4} = (V_{F2} + V_{F3})$ can be satisfied, where $V_{Fn}$ denotes a forward voltage drop of each diode.

5. The low level clamp circuit as set forth in any one of claims 1 to 4, wherein said first, second, third and fourth diodes (4, 6, 7, 9) are Schottky diodes.

6. A low level clamp circuit for clamping a clock signal at at least three predefined levels, comprising:-

    a source of a negative bias supply voltage ($E_{cc}$);

    input bias driving circuit means in circuit with a source of clock signals having at least two levels to be clamped, said input bias driving circuit means including a first negative bias driving circuit (1) for receiving said negative supply voltage and outputting a pulse corresponding to said negative bias supply voltage in response to a first clock pulse, and a second intermediate level driving circuit (2) for receiving a negative bias supply voltage through a first diode (4) with a first voltage drop in circuit with said negative bias supply voltage, said second intermediate level driving circuit (2) outputting a clock pulse with an amplitude corresponding to the difference between the negative bias supply voltage and the first forward voltage drop of said diode (1) to be stabilised in response to the first clock pulse;

    a clamping and smoothing circuit means for clamping a high level of the pulse outputted from said first negative bias driving circuit and outputting a clamped pulse therefrom, said clamping and smoothing circuit including a second diode (6) responsive to said first negative bias driving circuit (1) for clamping a high level of the pulse outputted therefrom, and a third diode (7) responsive to the high level clamped pulse outputted via said second diode (6) for outputting a negative bias dc output therefrom; and

    a fourth diode means (9) connected between said second intermediate level driving circuit (2) and said clamping and smoothing means for clamping a low level of the clock pulse outputted from said second intermediate level driving circuit to said clamping and smoothing means.

7. The circuit as set forth in claim 6, further including a third high level driving circuit (3) for receiving a third positive bias supply voltage and outputting a pulse superimposed upon the negative bias supply voltage applied to said second intermediate level driving circuit (2) in response to a second clock pulse.

8. The circuit as set forth in claim 6 or 7, wherein the negative bias supply voltage applied to said first negative bias driving circuit (1) is equal to the sum of the negative bias voltage applied to said second intermediate level driving circuit and the first forward voltage drop of said first diode (4).

9. The low level clamping circuit as set forth in claim 6, 7 or 8, wherein said first, second, third and fourth diodes (4, 6, 7, 9) are related so that the sum of the forward voltage drops of said first and fourth diodes is equal to the sum of the forward voltage drops of said second and third diodes.

10. The clamp circuit as set forth in claim 6 wherein said first, second, third and fourth diodes (4, 6, 7, 9) are Schottky diodes.

11. The circuit as set forth in claim 6 wherein said clamping and smoothing circuit includes a capacitor (8) in circuit with said third diode (7).

## Revendications

1. Circuit de verrouillage de niveau bas permettant de verrouiller un signal d'horloge sur au moins trois niveaux prédéfinis, comprenant:

(a) un premier circuit (1) de commande de polarisation négative servant à recevoir une tension d'alimentation de polarisation négative ($E_{cc}$) et à délivrer une impulsion' (a) dont l'amplitude correspond à la tension d'alimentation de polarisation négative reçue ($E_{cc}$) en réponse à une première impulsion d'horloge;

(b) une première diode (4) ayant une première chute de tension de sens passant ($V_{F1}$);

(c) un deuxième circuit de commande de niveau intermédiaire (2) servant à recevoir une tension d'alimentation de polarisation négative ($V_2$) via ladite première diode et à délivrer une impulsion d'horloge (b) dont l'amplitude correspond à la tension d'alimentation de polarisation négative reçue

($E_{cc}$ - $V_{F1}$)devant d'alimentation de polarisation négative reçue ($E_{cc}$ - $V_{F1}$) devant être stabilisée en réponse à la première impulsion d'horloge;

(d) une deuxième diode (6) qui répond audit premier circuit de commande de polarisation négative (1) en verrouillant un niveau haut de l'impulsion (a) délivrée par ledit premier circuit de commande de polarisation négative (1) et en délivrant une impulsion verrouillée (c);

(e) un circuit de redressement/filtrage comportant une troisième diode (7) et un condensateur (8), qui répond à l'impulsion verrouillée sur un niveau haut (c) délivrée par ladite deuxième diode en délivrant un signal de sortie continu de polarisation négative ($E_{dc}$,d); et

(f) une quatrième diode (9) connectée entre ledit deuxième circuit de commande de niveau intermédiaire (2) et ledit circuit de redressement/filtrage (8), qui sert à verrouiller un niveau bas de l'impulsion d'horloge (b) délivrée par ledit deuxième circuit de commande de niveau intermédiaire au signal de sortie continu de polarisation négative ($E_{dc}$, d) redressé/filtré.

2. Circuit de verrouillage de niveau bas selon la revendication 1, qui comprend en outre :

- un troisième circuit de commande de niveau haut (3) servant à recevoir une troisième tension d'alimentation de polarisation positive ($V_3$) et à délivrer une impulsion devant être superposée à la tension d'alimentation de polarisation négative ($E_{cc}$ - $V_{F1}$) appliquée audit deuxième circuit de commande de niveau intermédiaire en réponse à une deuxième impulsion d'horloge.

3. Circuit de verrouillage de niveau bas selon la revendication 1 ou 2, où la tension d'alimentation de polarisation négative ($E_{cc}$) qui est appliquée audit premier circuit de commande de polarisation négative est égale à la somme de la tension de polarisation négative ($V_2$) appliquée audit deuxième circuit de commande de niveau intermédiaire (2) et de la première chute de tension de sens passant ($V_{F1}$) de ladite première diode (4).

4. Circuit de verrouillage de niveau bas selon la revendication 1, 2 ou 3, où lesdites première, deuxième, troisième et quatrième diodes (4, 6, 7, 9) sont déterminées de façon que la relation $V_{F1} + V_{F4} = V_{F2} + V_{F3}$soit satisfaite, où $V_{Fn}$ désigne la chute de tension de sens passant de la diode respective.

5. Circuit de verrouillage de niveau bas selon l'une quelconque des revendications 1 à 4, où lesdites première, deuxième, troisième et quatrième diodes (4, 6, 7, 9) sont des diodes de Schottky.

6. Circuit de verrouillage de niveau bas permettant de verrouiller un signal d'horloge sur au moins trois niveaux prédéfinis, comprenant :
- une source de tension d'alimentation de polarisation négative ($E_{cc}$);
- un moyen constituant un circuit de commande de polarisation d'entrée qui est en circuit avec une source de signaux d'horloge possédant au moins deux niveaux à verrouiller, ledit moyen qui constitue un circuit de commande de polarisation d'entrée comportant un premier circuit de commande de polarisation négative (1) servant à recevoir ladite tension d'alimentation de polarisation négative et à délivrer une impulsion correspondant à ladite tension d'alimentation de polarisation négative en réponse à une première impulsion d'horloge, et un deuxième circuit de commande de niveau intermédiaire (2) servant à recevoir une tension d'alimentation de polarisation négative par l'intermédiaire d'une première diode (4), possédant une première chute de tension, en circuit avec ladite tension d'alimentation de polarisation négative, ledit deuxième circuit de commande de niveau intermédiaire (2) délivrant une impulsion d'horloge dont l'amplitude correspond à la différence entre la tension d'alimentation de polarisation négative et la première chute de tension de sens passant de ladite diode (1) à stabiliser en réponse à la première impulsion d'horloge;
- un moyen constituant un circuit de verrouillage et de filtrage, qui sert à verrouiller un niveau haut de l'impulsion délivrée par ledit premier circuit de commande de polarisation négative et à délivrer une impulsion verrouillée de celui-ci, ledit circuit de verrouillage et de filtrage comportant une deuxième diode (6) qui répond audit premier circuit de commande de polarisation négative (1) en verrouillant un niveau haut de l'impulsion délivrée par celui-ci, et une troisième diode (7) qui répond à l'impulsion verrouillée sur un niveau haut délivrée via ladite deuxième diode (6) en délivrant un signal de sortie continu de polarisation négative de celui-ci ;et
- un moyen constituant une quatrième diode (9), connectée entre ledit deuxième circuit de commande de niveau intermédiaire (2) et ledit circuit de verrouillage et de filtrage, afin de verrouiller un niveau bas de l'impulsion d'horloge délivrée par ledit deuxième circuit de commande de niveau intermédiaire audit circuit de verrouillage et de filtrage.

7. Circuit selon la revendication 6, comportant en outre un troisième circuit de commande de niveau haut (3) servant à recevoir une troisième tension d'alimentation de polarisation positive et à délivrer une impulsion superposée à la tension d'alimentation de polarisation négative qui est appliquée audit deuxième circuit de commande de niveau intermédiaire (2) en réponse à une deuxième impulsion d'horloge.

8. Circuit selon la revendication 6 ou 7, où la tension d'alimentation de polarisation négative appliquée audit premier circuit de commande de polarisation négative (1) est égale à la somme de la tension d'alimentation depolarisation négative appliquée audit deuxième circuit de commande de niveau intermédiaire et de la première chute de tension de sens passant de ladite première diode (4).

9. Circuit selon la revendication 6, 7 ou 8, où lesdites première, deuxième, troisième et quatrième diodes (4, 6, 7, 9) sont liées de façon que la somme des chutes de tension de sens passant desdites première et quatrième diodes soit égale à la somme des chutes de tension de sens passant desdites deuxième et troisième diodes.

10. Circuit selon la revendication 6, où lesdites première, deuxième, troisième et quatrième diodes (4, 6, 7, 9) sont des diodes de Schottky.

11. Circuit selon la revendication 6, où ledit circuit de verrouillage et de filtrage comporte un condensateur (8) qui est en circuit avec ladite troisième diode (7).

## Ansprüche

1. Niedrigpegel-Klemmschaltung zum Klemmen eines Taktsignals auf Wenigstens drei vorbestimmte Pegelhöhen, mit:
 (a) einem ersten negativen Vorspannungs-Treiberkreis (1), der eine negative Speise-Vorspannung ($E_{cc}$) empfängt und einen Impuls (a) mit einer mit der empfangenen negativen Speise-Vorspannung ($E_{cc}$) korrespondierenden Amplitude abhängig von einem ersten Taktsignal abgibt;
 (b) einer ersten Diode (4) mit einem ersten Vorwärts-Spannungsabfall ($V_{F1}$);
 (c) einen zweiten Zwischenpegel-Treiberkreis (2), der eine negative Speise-Vorspannung ($V_2$) über die erste Diode empfängt und einen Taktimpuls (b) mit einer mit der empfangenen, zu stabilisierenden negativen Speise-Vorspannung ($E_{cc}$-$V_{F1}$) korrespondierenden Amplitude abhängig von dem ersten Taktsignal abgibt;

(d) einer auf den ersten negativen Vorspannungs-Treiberkreis (1) ansprechenden, zweiten Diode (6) zum Klemmen eines hohen Pegels des vom ersten negativen Vorspannungs-Treiberkreis (1) abgegebenen Impulses (a) und Abgeben eines geklemmten Impulses (c);

(e) einem eine dritte Diode (7) und einen Kondensator (8) aufweisenden Gleichrichtungs/Glättungskreis, der abhängig von dem über die zweite Diode abgegebenen, auf hohen Pegel geklemmten Impuls (c) ein negatives Vorspannungs-Ausgangsgleichsignal ($E_{dc}$,d) abgibt; und

(f) einer zwischen dem zweiten Zwischenpegel-Treiberkreis (2) und dem Gleichrichtungs/Glättungskreis (8) angeschlossenen, vierten Diode (9) zum Klemmen eines niedrigen Pegels des vom zweiten Zwischenpegel-Treiberkreis abgegebenen Taktimpulses (b) auf das gleichgerichtete/geglättete negative Vorspannungs-Ausgangsgleichsignal ($E_{dc}$,d).

2. Niedrigpegel-Klemmschaltung nach Anspruch 1, ferner mit: einem dritten Hochpegel-Treiberkreis (3), der eine dritte positive Speise-Vorspannung ($V_3$) empfängt und abhängig von einem zweiten Taktsignal einen Impuls abgibt zur Überlagerung über die dem zweiten Zwischenpegel-Treiberkreis zugeführten negativen Speise-Vorspannung ($E_{cc}$-$V_{F1}$).

3. Niedrigpegel-Klemmschaltung nach Anspruch 1 oder 2, in welcher die an den ersten negativen Vorspannungs-Treiberkreis angelegte negative Speise-Vorspannung ($E_{cc}$) gleich einer Summe der an den zweiten Zwischenpegel-Treiberkreis (2) angelegten negativen Vorspannung ($V_2$) und des ersten Vorwärts-Spannungsabfalls ($V_{F1}$) der ersten Diode (4) ist.

4. Niedrigpegel-Klemmschaltung nach Anspruch 1, 2 oder 3, in welcher die erste, zweite, dritte und vierte Diode (4,6,7,9) so ausgelegt sind, daß $V_{F1} + V_{F4} = (V_{F2} + V_{F3})$ erfüllt werden kann, wobei $V_{Fn}$ einen Vorwärts-Spannungsabfall jeder Diode bezeichnet.

5. Niedrigpegel-Klemmschaltung nach einem der Ansprüche 1 bis 4, in welcher die erste, zweite, dritte und vierte Diode (4,6,7,9) Schottky-Dioden sind.

6. Niedrigpegel-Klemmschaltung zum Klemmen eines Taktsignals auf wenigstens drei vorbestimmte Pegelhöhen, mit:
einer Quelle einer negativen Speise-Vorspannung ($E_{cc}$);
einer Eingangs-Vorspannungs-Treiberkreiseinrichtung, in Schaltungsverbindung mit einer Taktsignal-Quelle mit wenigstens zwei zu klemmenden Pegelhöhen, wobei die Eingangsvorspannungs-Treiberkreiseinrichtung einen ersten negativen Vorspannungs-Treiberkreis (1) zum Empfang der negativen Speisespannung und Abgabe eines mit der negativen Speise-Vorspannung korrespondierenden Impulses abhängig von einem ersten Taktsignal und einen zweiten Zwischenpegel-Treiberkreis (2) zum Empfang einer negativen Speise-Vorspannung über eine erste Diode (4) mit einem ersten Spannungsabfall in Schaltungsverbindung mit der negativen Speise-Vorspannung umfaßt, und wobei der zweite Zwischenpegel-Treiberkreis (2) einen Taktimpuls mit einer der Differenz zwischen der negativen Speise-Vorspannung und dem ersten Vorwärts-Spannungsabfall der Diode (1) korrespondierenden Amplitude abgibt, die abhängig von dem ersten Taktsignal zu stabilisieren ist;
einer Klemm- und Glättungskreiseinrichtung zum Klemmen eines hohen Pegels des vom ersten negativen Vorspannungs-Treiberkreis abgegebenen Impulses und Abgeben eines geklemmten Impulses, wobei der Klemm- und Glättungskreis eine zweite Diode (6), die abhängig von dem ersten negativen Vorspannungs-Treiberkreis (1) einen hohen Pegel des davon abgegebenen Impulses klemmt, und eine dritte Diode (7) ausfweist die abhängig von dem von der zweiten Diode (6) abgegebenen auf den hohen Pegel geklemmte Impuls ein negatives Vorspannungs-Ausgangsgleichsignal abgibt; und
einer zwischen dem zweiten Zwischenpegel-Treiberkreis (2) und der Klemm- und Glättungseinrichtung angeschlossenen, vierten Diode (9) zum Klemmen eines niedrigen Pegels des vom zweiten Zwischenpegel-Treiberkreis zur Klemm- und Glättungseinrichtung abgegebenen Taktimpulses.

7. Schaltung nach Anspruch 6, ferner mit einem dritten Hochpegel-Treiberkreis (3) zum Empfang einer dritten positiven Speise-Vorspannung und Abgabe eines Impulses, der über die am zweiten Zwischenpegel-Treiberkreis (2) angelegte negative Speise-Vorspannung überlagert ist, abhängig von einem zweiten Taktsignal.

8. Schaltung nach Anspruch 6 oder 7, in welcher die an den ersten negativen Vorspannungs-Treiberkreis (1) angelegte negative Speise-Vorspannung gleich der Summe der an den zweiten Zwischenpegel-Treiberkreis angelegten negativen Vorspannung und dem ersten Vorwärts-Spannungsabfall der ersten Diode (4) ist.

9. Niedrigpegel-Klemmschaltung nach Anspruch 6,7 oder 8, in welcher die erste, zweite, dritte und vierte Diode (4,6,7,9) so in Beziehung zueinander stehen, daß die Summe der Vorwärts-Spannungsabfälle der ersten und vierten Diode gleich der Summe der Vorwärts-Spannungsabfälle der zweiten und dritten Diode ist.

10. Klemmschaltung nach Anspruch 6, in welcher die erste, zweite, dritte und vierte Diode (4,6,7,9) Schottky-Dioden sind.

11. Schaltung nach Anspruch 6, in welcher der Klemm- und Glättungskreis einen Kondensator (8) in Schaltungsverbindung mit der dritten Diode (7) aufweist.

THREE LEVEL CLOCK

*FIG. 1*

*FIG.4*

EP 0 224 325 B1

FIG.2
(PRIOR ART)

FIG.3